(19) Europäisches Patentamt / European Patent Office / Office européen des brevets

(11) **EP 3 084 014 B1**

(12) **FASCICULE DE BREVET EUROPEEN**

(45) Date de publication et mention
de la délivrance du brevet:
**08.05.2019 Bulletin 2019/19**

(21) Numéro de dépôt: **14821855.5**

(22) Date de dépôt: **05.12.2014**

(51) Int Cl.:
*C21D 8/02* *(2006.01)*    *C21D 8/04* *(2006.01)*
*C21D 9/46* *(2006.01)*    *C21D 9/48* *(2006.01)*
*C22C 38/00* *(2006.01)*   *C22C 38/02* *(2006.01)*
*C22C 38/06* *(2006.01)*   *C22C 38/22* *(2006.01)*
*C22C 38/26* *(2006.01)*   *C22C 38/38* *(2006.01)*
*C22C 38/28* *(2006.01)*   *C22C 38/32* *(2006.01)*
*C23C 2/02* *(2006.01)*    *C23C 2/06* *(2006.01)*
*C23C 2/28* *(2006.01)*    *C23C 2/40* *(2006.01)*
*C23C 14/16* *(2006.01)*

(86) Numéro de dépôt international:
**PCT/IB2014/066647**

(87) Numéro de publication internationale:
**WO 2015/087224 (18.06.2015 Gazette 2015/24)**

(54) **ACIER À HAUTE RÉSISTANCE ET PROCÉDÉ DE FABRICATION**

HOCHFESTER STAHL UND HERSTELLUNGSVERFAHREN DAFÜR

HIGH STRENGTH STEEL AND METHOD OF PRODUCTION OF THE SAME

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.12.2013 PCT/US2013/074482**

(43) Date de publication de la demande:
**26.10.2016 Bulletin 2016/43**

(73) Titulaire: **Arcelormittal
1160 Luxembourg (LU)**

(72) Inventeurs:
• DRILLET, Josée
F-57160 Rozerieulles (FR)
• HEBERT, Véronique
F-57070 Saint-Julien-les-Metz (FR)

(74) Mandataire: **Lavoix
2, place d'Estienne d'Orves
75441 Paris Cedex 09 (FR)**

(56) Documents cités:
EP-A1- 2 246 456    EP-A1- 2 258 887
EP-A1- 2 371 979    EP-A1- 2 426 230
EP-A1- 2 460 901    KR-A- 20120 049 622

• HIROSHI MATSUDA ET AL: "Effects of
auto-tempering behaviour of martensite on
mechanical properties of ultra high strength steel
sheets", JOURNAL OF ALLOYS AND
COMPOUNDS, vol. 577, 1 novembre 2013
(2013-11-01), pages S661-S667, XP055177592,
ISSN: 0925-8388, DOI:
10.1016/j.jallcom.2012.04.108

**Description**

La présente invention concerne une tôle d'acier laminée à froid et recuite présentant une très haute résistance mécanique et une aptitude à la déformation pour la fabrication de pièces par mise en forme, en particulier dans l'industrie automobile, pour la fabrication d'éléments de structure de caisse d'automobile, et la fabrication d'une telle tôle.

On a développé des aciers ayant un rapport limite d'élasticité/résistance très favorable lors des opérations de formage.

Leur capacité de consolidation est très grande, ce qui permet une bonne répartition des déformations dans le cas d'une collision et l'obtention d'une limite d'élasticité nettement plus importante sur pièce après formage. On peut réaliser ainsi des pièces aussi complexes qu'avec des aciers conventionnels, mais avec des propriétés mécaniques plus élevées, ce qui autorise une diminution d'épaisseur pour tenir un cahier des charges fonctionnel identique. De la sorte, ces aciers sont une réponse efficace aux exigences d'allègement et de sécurité des véhicules.

Notamment, des aciers dont la structure comprend de la martensite, éventuellement de la bainite, au sein d'une matrice ferritique, ont connu un grand développement car ils allient une résistance élevée à des possibilités importantes de déformation.

Les exigences récentes d'allègement et de réduction de la consommation d'énergie ont conduit à une demande accrue d'aciers à très haute résistance, dont la résistance mécanique TS est supérieure à 1180 MPa.

Outre ce niveau de résistance, ces aciers doivent présenter une bonne ductilité, une bonne soudabilité et une bonne aptitude au revêtement, notamment une bonne aptitude à la galvanisation en continu au trempé.

Ces aciers doivent également présenter une limite d'élasticité et un allongement à la rupture élevés ainsi qu'une bonne aptitude à la mise en forme.

En effet, certaines pièces automobiles sont fabriquées par des opérations de mise en forme combinant différents modes de déformation. Certaines caractéristiques microstructurales de l'acier peuvent se révéler bien adaptées à un mode de déformation, mais peu favorables vis-à-vis d'un autre mode. Certaines parties des pièces doivent présenter une haute résistance à l'allongement et/ou une bonne aptitude au pliage et/ou une bonne aptitude à la mise en forme d'un bord découpé.

Cette aptitude à la mise en forme d'un bord découpé est évaluée par détermination d'un rapport d'expansion de trou, noté Ac%. Ce rapport d'expansion de trou mesure l'aptitude de l'acier à subir une expansion lors d'un emboutissage à froid, et fournit donc une évaluation de l'aptitude à la mise en forme de l'acier dans ce mode de déformation.

Le rapport d'expansion de trou peut être évalué de la façon suivante : après réalisation d'un trou par découpe dans une tôle, on utilise un outil tronconique de façon à réaliser une expansion au niveau des bords de ce trou. C'est au cours de cette opération que l'on peut observer un endommagement précoce au voisinage des bords du trou lors de l'expansion, cet endommagement s'amorçant sur des particules de seconde phase ou aux interfaces entre les différents constituants microstructuraux dans l'acier.

Décrite dans la norme ISO 16630 :2009, la méthode d'expansion de trou consiste à mesurer le diamètre initial Di du trou avant emboutissage, puis le diamètre final Df du trou après emboutissage, déterminé au moment où l'on observe des fissures traversantes dans l'épaisseur de la tôle sur les bords du trou. On détermine alors l'aptitude à

$$Ac\% = 100 * \frac{D_f - D_i}{D_i} .$$

l'expansion de trou Ac% selon la formule suivante :

Ac% permet donc de quantifier l'aptitude d'une tôle à résister à un emboutissage au niveau d'un orifice découpé. Selon cette méthode, le diamètre initial est de 10 millimètres.

D'après les documents US 2012/0312433 A1 et US 2012/132327 A1, on connaît des aciers dont la résistance mécanique TS est supérieure à 1180 MPa. Néanmoins, cette résistance mécanique est obtenue au détriment de l'aptitude à la mise en forme et de la soudabilité.

Par ailleurs, d'après les documents US 2013/0209833 A1, US 2011/0048589 A1 (également publié en tant que EP 2 258 887 A1), US 2011/01683000 A1 et WO 2013/144376 A1, on connaît des aciers ayant une résistance mécanique élevée pouvant dépasser 1000MPa, mais ne présentant pas simultanément une aptitude à la mise en forme et une soudabilité satisfaisants.

Dans ces conditions, un but de l'invention consiste à mettre à disposition une tôle d'acier présentant une résistance mécanique élevée, notamment comprise entre 1180 et 1320 MPa, conjointement avec une limite d'élasticité élevée, notamment comprise entre 800 et 970 MPa, cette valeur étant déterminée avant toute opération de skin-pass sur la tôle, une bonne aptitude à la mise en forme, notamment un rapport d'expansion de trou Ac% supérieur ou égal à 30%, un angle de pliage, pour une tôle d'épaisseur comprise entre 0,7 mm et 1,5 mm, supérieur ou égal à 55°, et un allongement à rupture supérieur à 5%.

A cet effet, l'invention a pour objet une tôle d'acier laminée à froid et recuite selon la revendication 1.

Dans des modes de réalisation, la tôle suivant l'invention comporte en outre une ou plusieurs des caractéristiques des revendications 2 à 14.

L'invention a également pour objet un procédé de fabrication d'une tôle laminée à froid et recuite selon la revendication 15.

L'invention a également pour objet un procédé de fabrication d'une tôle laminée à froid et recuite selon la revendication 16.

Dans des modes de réalisation, ce dernier procédé comporte en outre une ou plusieurs des caractéristiques des revendications 17 à 19.

D'autres caractéristiques et avantages de l'invention apparaîtront au cours de la description ci-dessous, donnée à titre d'exemple et faite en référence aux figures annexées ci-jointes parmi lesquelles :

- la Figure 1 présente la microstructure d'une tôle d'acier selon l'invention, mise en évidence par un premier type d'attaque ;
- la Figure 2 présente la microstructure de la tôle d'acier de la Figure 1, mise en évidence par un deuxième type attaque.

Dans toute la demande, on désignera par Ar3 la température de début de transformation de l'austénite au refroidissement.

On désignera par ailleurs par Ac1 la température de début de transformation allotropique au chauffage de l'acier.

On désignera par ailleurs par Ac3 la température de fin de transformation austénitique au chauffage telle que calculée par le logiciel Thermo-Calc®, connu en lui-même. Ce calcul ne fait pas intervenir le temps de maintien à la température Ac3.

Or, la température de fin de transformation austénitique au chauffage dépend de la durée de maintien au palier, notée Dm. On appellera ainsi Ac3' la température minimale de fin de transformation austénitique au chauffage corrigée, déterminée selon la formule : Ac3'=Min {Ac3+1200/Dm ; 1000°C}, où Ac3 et Ac3' sont exprimées en degrés Celsius et Dm en secondes. Min {Ac3+1200/Dm ; 1000°C} désigne ici la plus petite valeur parmi les deux quantités: (Ac3+1200/Dm), et 1000°C. Ainsi, si Ac3+1200/Dm est inférieure ou égale à 1000°C, Ac3'= Ac3+1200/Dm. En revanche si Ac3+1200/Dm est supérieure à 1000°C, Ac3'=1000°C. On considère ainsi que même lorsque la durée de maintien au palier est très courte, une température de 1000°C permet d'obtenir une structure austénitique.

Cette température Ac3' est telle que lorsque l'acier est maintenu à la température Ac3' pendant une durée de maintien égale à Dm, la tôle est entièrement en phase austénitique.

La martensite est issue de la transformation sans diffusion de l'austénite $\gamma$ en dessous de la température de début de transformation martensitique Ms au refroidissement.

La martensite se présente sous la forme de fines lattes allongées dans une direction, et orientées à l'intérieur de chaque grain initial d'austénite. Le terme martensite inclut à la fois la martensite fraîche et la martensite auto-revenue.

On distinguera par la suite la martensite auto-revenue de la martensite fraîche (i.e. non revenue et non auto-revenue).

Notamment, la martensite auto-revenue est présente sous la forme de fines lattes comprenant des carbures de fer dispersés dans ces lattes, sous forme de bâtonnets orientés selon les directions <111> de la maille $\alpha$ des lattes. Cette martensite auto-revenue est formée dans le cas d'un cycle refroidissement rapide en-dessous de la température de transformation martensitique Ms. Les carbures de fer dispersés dans les lattes sont formés par précipitation en-dessous de la température de transformation martensitique Ms lorsque le refroidissement n'est pas suffisamment lent pour produire de la martensite fraîche. Au contraire, la martensite fraîche ne comprend pas de carbures.

La bainite, formée lors d'un refroidissement depuis le domaine austénitique, au-dessus de la température de début de transformation martensitique Ms, se présente sous la forme d'un agrégat de lattes de ferrite et de particules de cémentite. Sa formation fait intervenir une diffusion à courte distance.

On distinguera par la suite la bainite inférieure de la bainite à faible quantité de carbures.

La bainite inférieure est formée, lors du refroidissement, dans une gamme de températures immédiatement supérieure à la température de début de transformation martensitique Ms. Elle se présente sous forme de fines lattes et comprend des carbures dispersés dans ces lattes.

Par ailleurs, on appellera bainite à faible quantité de carbures de la bainite contenant moins de 100 carbures par unité de surface de 100 micromètres carrés. La bainite à faible quantité de carbures est formée, lors du refroidissement, entre 550°C et 450°C.

Au contraire de la bainite à faible quantité de carbures, la bainite inférieure contient toujours plus de 100 carbures par unité de surface de 100 micromètres carrés.

Dans la composition chimique de l'acier, le carbone joue un rôle sur la formation de la microstructure et sur les propriétés mécaniques.

La teneur en poids en carbone est comprise entre 0,10% et 0,13%. Cette gamme de teneur en carbone permet d'obtenir simultanément une résistance mécanique supérieure à 1180 MPa, un allongement à la rupture supérieur à 5%, et un rapport d'expansion de trou Ac% satisfaisant, supérieur à 30%, voire supérieur à 40%. Notamment, une teneur en carbone inférieure à 0,10% ne permet pas d'atteindre une résistance mécanique suffisante. Pour une teneur en carbone plus élevée, supérieure à 0,13%, l'aptitude au soudage tend à diminuer. En outre, la température Ms baisse, de telle sorte que la fraction de martensite fraîche, i.e. non revenue et non auto-revenue, dans la microstructure, tend à augmenter et ainsi à dégrader le rapport d'expansion de trou.

La teneur en poids en manganèse est comprise entre 2,4% et 2,8%, de préférence entre 2,5% et 2,8%. Le manganèse est un élément gammagène, qui abaisse la température Ac3 et abaisse la température Ms de début de formation de la martensite. La faible teneur en carbone de l'acier pourrait conduire à une température Ac3 élevée, supérieure à 850°C. Une teneur en manganèse supérieure à 2,4% permet, en abaissant la valeur de la température Ac3, d'obtenir une austénisation complète de l'acier entre 840°C et 850°C, après un maintien à cette température pendant une durée d'au moins 50s. Le manganèse permet par ailleurs la formation de martensite auto-revenue et contribue donc à obtenir un rapport d'expansion de trou Ac% supérieur ou égal à 40%. La teneur en poids en manganèse est limitée à 2,8%, afin de limiter la formation de structures en bandes.

Le silicium est un élément participant au durcissement en solution solide, dont la teneur en poids dans l'acier est comprise entre 0,30% et 0,55% en poids, de préférence entre 0,30% et 0,5%. Une teneur d'au moins 0,30% permet d'obtenir un durcissement suffisant de la ferrite et/ou de la bainite. La teneur en poids en silicium est limitée à 0,55% pour garantir un rapport d'expansion de trou Ac% supérieur ou égal à 40%, en limitant la formation de bainite supérieure. En outre, une augmentation de la teneur en silicium dégraderait l'aptitude au revêtement de l'acier en favorisant la formation d'oxydes adhérents à la surface de la tôle.

Par ailleurs, le silicium diminue la soudabilité. La soudabilité peut notamment être estimée au moyen du carbone équivalent Ceq, par exemple calculé par la formule publiée par Nishi, T et al., dans "Evaluation of high-strength steels for automobile use », Nippon Steel technical report, No. 20, pp. 37-44, 1982, dans laquelle les teneurs des éléments sont exprimées en poids :

$$Ceq = C + Mn/20 + Si/30 + P + S*2.$$

Une teneur en silicium inférieure à 0,55% contribue notamment à garantir à la fois une très bonne aptitude au soudage, notamment un carbone équivalent calculé selon la formule de Nishi inférieur ou égal à 0,30%, ainsi qu'une bonne revêtabilité.

Le silicium est également alphagène, et contribue donc à élever la température Ac3, ainsi qu'à favoriser la formation de bainite à faible quantité de carbures. Une teneur en silicium inférieure à 0,55% contribue ainsi à éviter la formation d'une quantité trop importante de bainite à faible quantité de carbures.

La composition de la tôle en acier comporte par ailleurs du chrome en quantité supérieure ou égale à 0,30% en poids, de façon à améliorer la trempabilité de l'acier, et à augmenter sa dureté ainsi que sa résistance mécanique. La teneur en chrome doit être inférieure ou égale à 0,56%, de façon à conserver un allongement à la rupture satisfaisant et à limiter les coûts.

Le titane est présent dans l'acier en quantité comprise entre 0,020% et 0,050% en poids. En quantité comprise entre 0,020% et 0,050%, le titane se combine essentiellement à l'azote et au carbone pour précipiter sous forme de nitrures et/ou de carbonitrures. En deçà de 0,020%, la résistance mécanique de 1180 MPa n'est pas atteinte. Le titane a également une influence positive sur la soudabilité de l'acier.

Au-delà d'une teneur en titane de 0,050%, il existe un risque de former des nitrures de titane grossiers précipités dès l'état liquide, qui tendent à réduire la ductilité, et conduire à un endommagement précoce lors de l'expansion de trou. En effet, lorsque des nitrures de taille supérieure à 6 microns sont présents, on constate que ceux-ci sont majoritairement à l'origine des décohésions avec la matrice lors des étapes de découpe et d'emboutissage. Le titane permet par ailleurs de faire en sorte que l'azote soit entièrement combiné sous forme de nitrures ou de carbonitrures, si bien que le bore se trouve sous forme libre et peut jouer un rôle efficace sur la trempabilité

La teneur en poids en bore est comprise entre 0,0020% et 0,0040%. En limitant l'activité du carbone, le bore permet en effet de contrôler et de limiter les transformations de phase diffusives (transformation ferritique ou perlitique lors du refroidissement) et de former des phases durcissantes (bainite ou martensite) nécessaires à l'obtention de hautes caractéristiques de résistance mécanique. L'ajout de bore permet par ailleurs de limiter l'addition d'éléments trempants tels que Mn, Mo, Cr et de réduire le coût analytique de la nuance d'acier. Selon l'invention, la teneur minimale en bore pour assurer une trempabilité efficace est de 0,0020%. Au delà de 0,0040%, l'effet sur la trempabilité est saturé et on constate un effet néfaste sur la revêtabilité et sur la ductilité.

La composition de la tôle en acier comporte par ailleurs optionnellement du molybdène, en quantité inférieure à 0,010% en poids. Le molybdène joue, comme le chrome, un rôle efficace sur la trempabilité. Cependant, une teneur supérieure à 0,010% accroît excessivement le coût des additions.

La composition chimique de la tôle d'acier laminée à chaud comporte optionnellement du niobium, avec une teneur en poids inférieure à 0,040%. Au delà d'une teneur en poids de 0,040%, la recristallisation de l'austénite est retardée. La structure contient alors une fraction significative de grains allongés, ce qui ne permet plus d'atteindre le rapport d'expansion de trou Ac% visé.

En outre, il est prévu que la teneur en poids de l'azote soit comprise entre 0,002% et 0,008%. Afin de former une quantité suffisante de nitrures et de carbonitrures, la teneur en azote doit être supérieure à 0,002%. La teneur en azote doit être inférieure à 0,008% dans le but d'éviter une précipitation de nitrures de bore, ce qui diminuerait la quantité de bore libre.

Une teneur en poids en aluminium comprise entre 0,005% et 0,050% permet d'assurer la désoxydation de l'acier pendant sa fabrication. Une teneur en aluminium doit être inférieure à 0,050%, voire inférieure à 0,030% pour éviter une élévation de la température Ac3 et éviter la formation de ferrite lors du refroidissement.

La composition comprend optionnellement du soufre et du phosphore.

La teneur en soufre doit être inférieure à 0,005%. Au-delà d'une teneur en soufre de 0,005%, la ductilité est réduite en raison de la présence excessive de sulfures tels que MnS qui diminuent l'aptitude à la déformation, en particulier le rapport d'expansion de trou Ac%.

La teneur en phosphore doit être inférieure à 0,020%. En effet, le phosphore est un élément qui confère un durcissement par solution solide mais qui diminue la soudabilité par points et la ductilité à chaud, particulièrement en raison de son aptitude à la ségrégation aux joints de grains ou à la co-ségrégation avec le manganèse.

La microstructure de la tôle d'acier selon l'invention comprend, en pourcentage surfacique, de 60 à 95% de martensite et de bainite inférieure, de 4 à 35% de bainite à faible quantité de carbures, de 0 à 5% de ferrite, et moins de 5% d'austénite résiduelle sous forme d'îlots.

Dans le cadre de l'invention, on considère la somme des fractions surfaciques de martensite et de bainite inférieure, cette fraction surfacique totale étant comprise entre 60 à 95%.

Comme précédemment indiqué, on distingue la martensite auto-revenue de la martensite fraîche , c'est-à-dire non revenue et non auto-revenue.

Selon un mode de réalisation, la martensite est formée notamment de martensite auto-revenue. Le pourcentage surfacique de la somme de la martensite auto-revenue et de la bainite inférieure est d'au moins 40% de l'ensemble de la microstructure, et jusqu'à 95%.

La martensite auto-revenue et la bainite inférieure sont présentes sous la forme de fines lattes, et comprennent des carbures dispersés dans ces lattes.

En particulier, la martensite auto-revenue et la bainite inférieure comprennent des carbures de fer $Fe_2C$ et $Fe_3C$ sous forme de bâtonnets orientés dans les directions <111> de la maille $\alpha$ des lattes martensitiques et bainitiques.

Les pourcentages de martensite auto-revenue et de bainite inférieure sont spécifiés conjointement car la martensite auto-revenue et la bainite inférieure ont sensiblement le même rôle sur les propriétés d'usage de l'acier. De plus, ces deux constituants, présents sous forme de fines lattes, ne peuvent être identifiés individuellement l'un de l'autre lors d'observations en microscopie électronique à balayage.

Un pourcentage surfacique de martensite auto-revenue et de bainite inférieure compris entre 40% et 95% permet de favoriser l'aptitude à la mise en forme de l'acier, notamment son aptitude au pliage et son aptitude à la mise en forme d'un bord découpé. Un pourcentage de martensite auto-revenue et de bainite inférieure d'au moins 40% permet ainsi d'obtenir un bon angle de pliage, notamment un angle de pliage pour des tôles d'épaisseur comprise entre 0,7 mm et 1,5 mm, d'au moins 55°, et un bon rapport d'expansion de trou Ac%, notamment supérieur ou égal à 40%.

Le pourcentage de martensite auto-revenue et de bainite inférieure dans la microstructure est de préférence inférieur à 95%, afin de conserver un pourcentage suffisant de bainite à faible quantité de carbures, permettant d'obtenir un allongement à la rupture d'au moins 5%.

La martensite peut par ailleurs comprendre en partie de la martensite fraîche, dans un pourcentage surfacique comprise entre 4 et 20% de l'ensemble de la microstructure, de préférence entre 4% et 15%.

La martensite fraîche ne comprend pas de carbures.

Le pourcentage surfacique de martensite fraîche doit être inférieur à 20%, de préférence inférieur à 15%, en particulier pour ne pas dégrader la fragilité de l'acier et pour assurer un bon rapport d'expansion de trou.

Notamment, le pourcentage surfacique de martensite fraîche sous forme de bandes doit être minimisé. On entend par bande de martensite un îlot de martensite de grande longueur présentant une morphologie allongée. En particulier, une telle bande présente une plus grande longueur correspondant à la direction de laminage de la tôle, à plus ou moins 10 degrés près. Cette morphologie allongée est caractérisée, d'une part par le rapport entre la plus grande longueur Lmax et la plus petite longueur Lmin de l'îlot, et d'autre part par la valeur de la taille maximale Lmax de l'îlot. Un îlot donné est considéré comme possédant une morphologie allongée, donc formant une bande, lorsque son rapport Lmax/Lmin est supérieur ou égal à 15 et lorsque sa plus grande longueur Lmax est supérieure à 30 $\mu m$.

La formation de ces bandes est favorisée par des teneurs en carbone et en manganèse élevées.

La minimisation du pourcentage surfacique de martensite fraîche sous forme de bandes, en particulier en-dessous de 10% de l'ensemble de la microstructure, permet notamment d'éviter une dégradation de l'angle de pliage.

La microstructure comprend en outre de 4 à 35% de bainite à faible quantité de carbures, c'est-à-dire comprenant moins de 100 carbures par unité de surface de 100 micromètres carrés.

La bainite à faible quantité de carbures est formée lors du refroidissement entre 550°C et 450°C. Sa formation est favorisée notamment grâce à l'addition de silicium qui tend à retarder la précipitation des carbures, conjointement avec une faible quantité d'éléments trempants tels que le carbone ou le manganèse.

La bainite à faible quantité de carbures permet d'augmenter l'allongement à la rupture. En particulier, un pourcentage surfacique de bainite à faible quantité de carbures d'au moins 4% permet d'obtenir un allongement à la rupture d'au moins 5%. Le pourcentage surfacique de bainite à faible quantité de carbures doit être limité à 35% afin de garantir un rapport d'expansion de trou supérieur ou égal à 40% et une résistance mécanique supérieure ou égale à 1180 MPa.

La microstructure comprend par ailleurs de 0 à 5% de ferrite, de préférence de 4 à 5%. Le pourcentage surfacique de ferrite doit être d'au plus 5% afin d'assurer une bonne aptitude au pliage, ainsi qu'une résistance supérieure à 1180 MPa.

La microstructure peut contenir de l'austénite résiduelle sous la forme d'îlots, formant notamment des plaquettes entre les lattes de martensite auto-revenue et de bainite inférieure. Le pourcentage surfacique d'austénite résiduelle est inférieur à 5%.

De préférence, la plus petite dimension de ces îlots d'austénite résiduelle est inférieure à 50 nanomètres.

Par ailleurs, les inventeurs ont également mis en évidence l'importance du contrôle de la taille des grains austénitiques créés lors du recuit de la tôle laminée à froid, c'est-à-dire existant à haute température à l'issue du maintien de recuit, avant le refroidissement ultérieur. Ces grains austénitiques sont qualifiés « d'anciens grains austénitiques », car ces grains sont remplacés par d'autres constituants lors des transformations allotropiques ultérieures au refroidissement. Comme on va l'expliquer, la taille de ces anciens grains austénitiques peut néanmoins être mise en évidence par différentes méthodes, sur le produit final. Selon l'invention, la fraction des anciens grains austénitiques dont la taille est inférieure à un micromètre, représente moins de 10% de la population totale de ces anciens grains austénitiques.

La fraction des anciens grains austénitiques dont la taille est inférieure à un micromètre est par exemple déterminée au moyen d'un réactif approprié, dont la vitesse d'attaque dépend de certaines ségrégations locales aux anciens joints, tel que par exemple le réactif Béchet-Beaujard. A cet effet, un échantillon d'acier à l'état final, c'est-à-dire à l'issue du procédé de fabrication selon l'invention, est attaqué par un réactif approprié, notamment un réactif composé d'une solution aqueuse saturée d'acide picrique additionnée d'au moins 0,5% d'alkylsulfonate de sodium, pendant une durée comprise entre quelques minutes et une heure.

A l'issue de cette attaque, un examen micrographique de l'échantillon permet de visualiser les joints des anciens grains austénitiques, et de réaliser un histogramme de la taille de ces anciens grains austénitiques, notamment de déterminer la fraction des anciens grains austénitiques dont la taille est inférieure à un micromètre.

Alternativement, la taille des anciens grains austénitiques peut être déterminée au moyen d'une trempe interrompue lors du refroidissement après recuit, en adoptant des conditions de refroidissement initial de façon à provoquer une germination ferritique intergranulaire, puis à interrompre celle-ci par trempe.

Les inventeurs ont mis en évidence que la taille de ces anciens grains d'austénite conditionne la cinétique de transformation de phase lors du refroidissement suivant le recuit. Notamment, les grains austénitiques de faible taille, inférieure à un micromètre, contribuent à abaisser la valeur de la température Ms et ainsi à augmenter la formation de martensite fraîche.

A l'inverse, la présence de gros grains austénitiques diminue la formation de bainite à faible quantité de carbures.

Une fraction d'anciens grains austénitiques dont la taille est inférieure à un micromètre, inférieure à 10% de la population totale des grains austénitiques contribue donc notamment à obtenir un rapport d'expansion de trou Ac% supérieur ou égal à 40% et un angle de pliage, pour des tôles d'épaisseur comprise entre 0,7 mm et 1,5 mm, d'au moins 55°.

Ces caractéristiques microstructurales sont déterminées par exemple en observant la microstructure par Microscopie Electronique à Balayage au moyen d'un canon à effet de champ (technique « MEB-FEG ») à un grandissement supérieur à 1200x, couplé à un détecteur EBSD (« Electron Backscatter Diffraction »). Les morphologies des lattes et des grains sont ensuite déterminées par analyse d'images au moyen de logiciels connus en eux-mêmes, par exemple le logiciel Aphelion®.

La tôle d'acier laminée à froid et recuite selon l'invention peut être produite nue, sans revêtement, mais elle peut également être revêtue. Par exemple, un tel revêtement peut être formé de zinc ou d'alliage de zinc, notamment un revêtement galvanisé-allié comprenant de 7 à 12% en poids de fer.

Notamment, une telle tôle d'acier est bien adaptée au dépôt d'un revêtement métallique, en particulier par galvanisation au trempé selon les procédés usuels.

En particulier, la composition et les caractéristiques mécaniques de l'acier sont compatibles avec les contraintes et les cycles thermiques des procédés de revêtement de zinc au trempé en continu.

Le procédé de revêtement utilisé dépend de l'application visée. Notamment, le revêtement peut être obtenu au trempé, par une technique de dépôt sous vide telle que JVD (Jet Vapor Deposition), ou bien par électrodéposition cationique.

Les inventeurs ont mis en évidence le fait qu'une tôle d'acier selon l'invention présente une résistance mécanique comprise entre 1180 et 1320 MPa, conjointement avec une limite d'élasticité comprise entre 800 et 970 MPa, avant toute opération de skin-pass, un allongement à la rupture d'au moins 5%, notamment supérieur à 8%, et un rapport d'expansion de trou Ac% supérieur ou égal à 30%, notamment supérieur ou égal à 40%.

En particulier, une limite d'élasticité comprise entre 800 et 970 MPa est obtenue tout en conservant une résistance mécanique inférieure à 1320 MPa. En outre, une telle tôle présente un angle de pliage élevé. En particulier, lorsque la tôle a une épaisseur comprise entre 0,7 mm et 1,5 mm, l'angle de pliage est d'au moins 55°.

La mise en oeuvre du procédé de fabrication d'une tôle laminée selon l'invention comporte les étapes successives suivantes.

On approvisionne un acier de composition selon l'invention, et on procède à la coulée d'un demi-produit à partir de cet acier. Cette coulée peut être réalisée en lingots ou en continu sous forme de brames d'épaisseur de l'ordre de 200mm.

Les demi-produits coulés sont tout d'abord portés à une température $T_R$ supérieure à 1250 °C, afin d'homogénéiser l'acier et de dissoudre complètement les précipités.

Puis, on lamine à chaud le demi-produit dans un domaine de température où la structure de l'acier est totalement austénitique, c'est-à-dire à une température $T_{FL}$ supérieure à la température Ar3 de début de transformation de l'austénite au refroidissement. Si la température $T_{FL}$ est inférieure à la température Ar3, les grains de ferrite sont écrouis par le laminage et la ductilité est réduite. Préférentiellement, on choisira une température de fin de laminage supérieure à 875°C.

La tôle laminée à chaud est refroidie à une vitesse suffisante pour éviter la formation de ferrite et de perlite, notamment supérieure à 30°C/s, puis la tôle laminée à chaud est bobinée à une température $T_{Bob}$ comprise entre 500°C et 580°C. La température de bobinage doit être inférieure à 580°C pour éviter une oxydation lors du bobinage. Une température de bobinage trop basse, i.e. inférieure à 500°C, conduit à une augmentation de la dureté de l'acier, ce qui augmente les efforts nécessaires lors du laminage à froid ultérieur. La gamme de température de bobinage permet également d'éviter la formation de perlite.

On effectue ensuite un laminage à froid, avec un taux de réduction par exemple compris entre 40% et 70% de façon à introduire une quantité de déformation permettant une recristallisation ultérieure.

On chauffe ensuite la tôle laminée à froid, préférentiellement au sein d'une installation de recuit continu, avec une vitesse moyenne de chauffage $V_C$ comprise entre 1°C/s et 20°C/s entre 600°C et la température Ac1 (température de début de transformation allotropique en austénite au chauffage).

La température Ac1 peut être mesurée par dilatométrie, ou évaluée au moyen de la formule suivante publiée dans « Darstellung der Umwandlungen für technische Anwendungen und Möglichkeiten ihrer Beeinflussung », H.P. Hougardy, Werkstoffkunde Stahl Band 1,198-231, Verlag Stahleisen, Düsseldorf, 1984 :

$$Ac1 = 739 - 22*C - 7*Mn + 2*Si + 14*Cr + 13*Mo - 13*Ni.$$

Dans cette formule, la température Ac1 est exprimée en degrés Celsius, et C, Mn, Si Cr, Mo et Ni désignent les pourcentages en poids de C, Mn, Si, Cr, Mo et Ni respectivement dans la composition.

Lors du chauffage de l'acier entre 600°C et Ac1, il s'effectue un début de recristallisation et il se forme dans l'acier des précipités de TiNbCN, qui permettent de contrôler la distribution de la taille des grains austénitiques formés à partir de Ac1.

D'une manière surprenante, les inventeurs ont mis en évidence le fait que le contrôle de la vitesse moyenne de chauffage $V_C$ entre 600°C et Ac1 et ainsi du temps de chauffe entre 600°C et Ac1, qui correspond au temps entre le début de recristallisation et le début de la transformation de phase, est déterminant pour les cinétiques des transformations de phases ultérieures, notamment lors de la phase de maintien ultérieure à la température de recuit $T_M$. Les inventeurs ont ainsi mis en évidence, de manière inattendue, que le choix d'une vitesse moyenne chauffage $V_C$ entre 600°C et Ac1 comprise entre 1°C/s et 20°C/s permet, à l'issue du procédé de fabrication, d'obtenir un acier dont la microstructure est constituée, en proportion surfacique, de 60 à 95% de martensite et de bainite inférieure, de 4 à 35% de bainite à faible quantité de carbures, de 0 à 5% de ferrite, et moins de 5% d'austénite résiduelle sous forme d'îlots.

Notamment, une vitesse moyenne de chauffage $V_C$ inférieure à 1°C/s conduirait à une durée trop longue du chauffage entre 600°C et Ac1, donc à une formation trop importante de ferrite et à une résistance mécanique trop faible.

Au contraire, une vitesse moyenne de chauffage $V_C$ supérieure à 20°C/s conduirait à un temps de chauffe entre 600°C et Ac1 trop faible, et à une croissance insuffisante des grains ferritiques lors du chauffage entre 600°C et Ac1.

Or, les inventeurs ont mis en évidence la taille des grains ferritiques obtenus à l'issue du chauffage entre 600°C et Ac1 a une influence sur la taille des grains d'austénite à l'issue de l'austénisation. Une croissance insuffisante des grains ferritiques entraîne en effet une formation d'une fraction trop importante de petits grains d'austénite, donc à une formation insuffisante de martensite auto-revenue à l'issue du recuit, c'est à dire inférieure à 40%, en raison de l'abaissement de la valeur de la température $M_S$.

On chauffe ensuite la tôle laminée à froid depuis la température Ac1 jusqu'à une température de recuit $T_M$ comprise entre Ac3'-10°C et Ac3'+30°C, et on maintient la tôle laminée à froid à la température $T_M$ pendant une durée Dm comprise entre 50 et 150 secondes.

Comme indiqué ci-dessus, la température Ac3' dépend de la durée de maintien au palier. La durée Dm est choisie de telle sorte que la fraction des grains austénitiques dont la taille est inférieure à un micromètre représente moins de 10% de la population totale des grains austénitiques. En particulier, la durée de maintien Dm doit être suffisamment importante pour former des grains austénitiques suffisamment gros. A titre préférentiel, on choisira une taille de grains moyenne supérieure à 3 microns, idéalement comprise entre 5 et 10 microns.

En outre, une durée de maintien Dm inférieure à 50s conduirait à la formation à l'issue du procédé d'une proportion trop importante de ferrite.

La taille des grains austénitiques conditionne la cinétique de transformation de phase lors du refroidissement suivant le recuit. Notamment, les grains austénitiques de faible taille, inférieure à un micromètre, contribuent à abaisser la valeur de la température Ms et ainsi à diminuer la formation de martensite auto-revenue.

Le chauffage de la tôle laminée à froid à une vitesse moyenne de chauffage $V_C$ comprise entre 1°C/s et 20°C/s entre 600°C et la température Ac1, suivi du chauffage de la tôle laminée à froid entre Ac1 et $T_M$ et du maintien de la tôle laminée à froid à la température $T_M$ pendant la durée Dm comprise entre 50 et 100 secondes permet ainsi de contrôler la taille des grains d'austénite formés, et plus particulièrement de contrôler la fraction de ces grains dont la taille est inférieure à un micromètre.

Ces paramètres de chauffage permettent d'obtenir la microstructure selon l'invention à l'issue du recuit, et contribuent ainsi à l'obtention des caractéristiques mécaniques désirées.

La tôle d'acier est ensuite refroidie à une vitesse $V_R$ comprise entre 10 et 100°C/s jusqu'à une température Te comprise entre 460°C et 490°C. La vitesse de refroidissement $V_R$ doit être supérieure à 10°C/s afin de former moins de 5% de ferrite et de ne pas former trop de bainite à faible quantité de carbures.

Ce refroidissement peut être effectué à partir de la température $T_M$ en une seule ou en plusieurs étapes et peut faire intervenir dans ce dernier cas différents modes de refroidissement tels que des bains d'eau froide ou bouillante, des jets d'eau ou de gaz.

On maintient alors la tôle à la température Te pendant une durée De comprise entre 5 et 150 secondes.

Une transformation partielle de l'austénite en bainite intervient à ce stade. Le maintien à Te doit être inférieur à 150s de façon à limiter la proportion surfacique de bainite et obtenir ainsi une proportion suffisante de martensite.

Les étapes suivantes du procédé diffèrent selon que l'on fabrique une tôle d'acier galvanisée en continu, notamment galvanisée-alliée, ou non revêtue.

Selon un premier mode de réalisation, correspondant à la fabrication d'une tôle d'acier galvanisée en continu, on revêt la tôle par passage en continu en immersion dans un bain de zinc ou en alliage de zinc à une température TZn comprise entre 450°C et 480°C, pendant quelques secondes. Les températures Te et TZn sont telles que 0≤ (Te-TZn) ≤10°C.

On refroidit ensuite le produit galvanisé jusqu'à la température ambiante en transformant une grande fraction de l'austénite restante en martensite fraîche et/ou en bainite inférieure. On obtient de la sorte une tôle d'acier laminée à froid, recuite et galvanisée contenant en proportion surfacique de 60 à 95% de martensite et de bainite inférieure, de 4 à 35% de bainite à faible quantité de carbures, de 0 à 5% de ferrite, et moins de 5% d'austénite résiduelle sous forme d'îlots.

Dans le cas où l'on souhaite fabriquer une tôle d'acier laminée à froid, recuite et « galvannealed », c'est-à-dire galvanisée-alliée, on chauffe le produit galvanisé immédiatement à la sortie du bain de zinc ou d'alliage de zinc à une température $T_G$ comprise entre 490 et 550°C pendant une durée $t_G$ comprise entre 10 et 40s. On provoque ainsi l'interdiffusion du fer et de la fine couche de zinc ou d'alliage de zinc déposée lors de l'immersion, ce qui permet d'obtenir une tôle galvanisée-alliée.

On refroidit ensuite la tôle galvanisée-alliée jusqu'à la température ambiante en transformant une grande fraction de l'austénite restante en martensite fraîche et/ou en bainite inférieure. On obtient de la sorte une tôle d'acier laminée à froid, recuite et galvanisée-alliée contenant en proportion surfacique de 60 à 95% de martensite et de bainite inférieure, de 4 à 35% de bainite à faible quantité de carbures, de 0 à 5% de ferrite, et moins de 5% d'austénite résiduelle sous forme d'îlots.

Selon un deuxième mode de réalisation, correspondant à la fabrication d'une tôle d'acier non revêtue, on effectue à partir de la température Te un refroidissement de la tôle jusqu'à la température ambiante pour obtenir une tôle d'acier laminée à froid et recuite non revêtue contenant en proportion surfacique de 60 à 95% de martensite et de bainite inférieure, de 4 à 35% de bainite à faible quantité de carbures, de 0 à 5% de ferrite, et moins de 5% d'austénite résiduelle sous forme d'îlots.

Selon un troisième mode de réalisation, correspondant à la fabrication d'une tôle d'acier revêtue sous vide, on effectue comme pour le deuxième mode de réalisation, à partir de la température Te, un refroidissement de la tôle jusqu'à la température ambiante, puis on effectue un dépôt sous vide d'un revêtement en zinc ou en alliage de zinc, par exemple par dépôt physique en phase vapeur (PVD) ou par une méthode de type « Jet Vapour Déposition » (JVD). On obtient alors une tôle d'acier laminée à froid et recuite revêtue contenant en proportion surfacique de 60 à 95% de martensite et de bainite inférieure, de 4 à 35% de bainite à faible quantité de carbures, de 0 à 5% de ferrite, et moins de 5% d'austénite résiduelle sous forme d'îlots.

Les inventeurs ont mis en évidence le fait que la mise en oeuvre de ce procédé permet d'obtenir une tôle d'acier présentant une résistance mécanique comprise entre 1180 et 1320 MPa, conjointement avec une limite d'élasticité comprise entre 800 et 970 MPa (avant toute opération de skin-pass), un allongement à la rupture d'au moins 5%, voire 8%, dont le rapport d'expansion de trou Ac% est supérieur ou égal à 30%, et même supérieur ou égal à 40%.

En outre, la mise en oeuvre de ce procédé permet d'assurer à la tôle un angle de pliage d'au moins 55° lorsque la tôle a une épaisseur comprise entre 0,7 mm et 1,5 mm.

Par ailleurs, la tôle obtenue présente une bonne aptitude au soudage au moyen des procédés d'assemblage usuels tels que le soudage par résistance par points.

A titre d'exemple non limitatif, les résultats suivants vont montrer les caractéristiques avantageuses conférées par l'invention.

On a approvisionné des demi-produits d'acier dont les compositions, exprimées en teneurs pondérales (%) sont données dans le tableau 1 ci-dessous.

Outre les aciers I1 à I4 ayant servi à la fabrication de tôles selon l'invention, on a indiqué à titre de comparaison la composition d'aciers R1 à R9 ayant servi à la fabrication de tôles de référence.

Tableau 1

| | C % | Mn % | Si % | Cr % | Ti % | B % | Al % | Mo % | Nb % | N % | S % | P % |
|---|---|---|---|---|---|---|---|---|---|---|---|---|
| I1 | 0,128 | 2,484 | 0,317 | 0,514 | 0,039 | 0,0024 | 0,026 | 0,002 | 0,016 | 0,0051 | 0,003 | 0,015 |
| I2 | 0,130 | 2,494 | 0,529 | 0,516 | 0,040 | 0,0022 | 0,026 | 0,002 | 0,016 | 0,0054 | 0,003 | 0,015 |
| I3 | 0,109 | 2,795 | 0,339 | 0,551 | 0,035 | 0,0039 | 0,028 | 0,003 | 0,039 | 0,0047 | 0,003 | 0,015 |
| I4 | 0,130 | 2,500 | 0,505 | 0,524 | 0,037 | 0,0021 | 0,030 | 0,002 | <0,002 | 0,0050 | 0,003 | 0,015 |
| I5 | 0,130 | 2,700 | 0,324 | 0,313 | 0,045 | 0,0034 | 0,030 | 0,002 | 0,029 | 0,0076 | 0,003 | 0,015 |
| R1 | 0,134 | 2,515 | 0,536 | 0,574 | 0,043 | 0,0045 | 0,017 | 0,002 | 0,031 | 0,0059 | 0,003 | 0,015 |
| R2 | 0,086 | 2,492 | 0,309 | 0,519 | 0,040 | 0,0039 | 0,028 | 0,003 | 0,028 | 0,0050 | 0,003 | 0,015 |
| R3 | 0,087 | 2,584 | 0,310 | 0,520 | 0,039 | 0,0038 | 0,025 | 0,003 | 0,034 | 0,0051 | 0,003 | 0,015 |
| R4 | 0,168 | 2,873 | 0,230 | 0,040 | 0,023 | 0,0012 | 0,030 | 0,002 | 0,055 | 0,0063 | 0,003 | 0,015 |
| R5 | 0,117 | 2,245 | 0,507 | 0,515 | 0,029 | 0,0035 | 0,029 | 0,002 | 0,018 | 0,0055 | 0,003 | 0,015 |
| R6 | 0,119 | 2,239 | 0,511 | 0,515 | 0,028 | 0,0038 | 0,027 | 0,051 | 0,018 | 0,0058 | 0,003 | 0,015 |
| R7 | 0,123 | 2,489 | 0,503 | 0,521 | 0,036 | 0,0020 | 0,026 | 0,056 | <0,002 | 0,0051 | 0,003 | 0,015 |
| R8 | 0,124 | 2,489 | 0,505 | 0,522 | 0,037 | 0,0020 | 0,030 | 0,056 | 0,018 | 0,0055 | 0,003 | 0,015 |
| R9 | 0,124 | 2,485 | 0,682 | 0,521 | 0,037 | 0,0020 | 0,030 | 0,056 | 0,018 | 0,0060 | 0,003 | 0,015 |

Les valeurs soulignées sont non-conformes à l'invention.

On a calculé la température Ac3 au moyen du logiciel Thermo-Calc®, la température de début de transformation martensitique Ms et le carbone équivalent Ceq correspondant à chacune de ces compositions. Ces valeurs sont rapportées dans le tableau 2 ci-dessous.

En particulier, la température Ms a été déterminée à partir de la formule suivante publiée par K.W. Andrews, dans « Empirical Formulae for the Calculation of Some Transformation Temperatures », Journal of the Iron and Steel Institute, 203, Part 7, 1965, dans laquelle les teneurs des éléments sont exprimées en pourcentage pondéral :

$$Ms\ (°C) = 539 - 423\ C - 30,4\ Mn - 17,7\ Ni - 12,1\ Cr - 11\ Si - 7\ Mo.$$

Le carbone équivalent Ceq a été déterminé à partir de la formule de Nishi indiquée ci-dessus.

Les valeurs soulignées sont non-conformes à l'invention.

Tableau 2

|  | Ceq (%) | Ms (°C) | Ac3 (°C) |
|---|---|---|---|
| I1 | 0,28 | 400 | 795 |
| I2 | 0,29 | 396 | 800 |
| I3 | 0,28 | 398 | 798 |
| I4 | 0,29 | 396 | 800 |
| I5 | 0,30 | 395 | 798 |
| R1 | 0,30 | 393 | 803 |
| R2 | 0,24 | 417 | 805 |
| R3 | 0,25 | 414 | 805 |
| R4 | 0,34 | 378 | 785 |
| R5 | 0,27 | 409 | 820 |
| R6 | 0,27 | 408 | 820 |
| R7 | 0,29 | 399 | 802 |
| R8 | 0,29 | 399 | 804 |
| R9 | 0,29 | 397 | 810 |

Des demi-produits coulés correspondant aux compositions ci-dessus ont été réchauffés à une température $T_{reheat}$ supérieure à 1250°C, puis laminés à chaud, la température de fin de laminage étant égale à 850°C, donc supérieure à Ar3 pour tous ces aciers.

Puis les tôles laminées à chaud ont été refroidies en évitant la formation de ferrite et de perlite, puis bobinées à une température de 545°C.

Les tôles ont ensuite été laminées à froid, jusqu'à une épaisseur de 1,4 mm.

Les tôles ont ensuite été réchauffées avec une vitesse de réchauffage $V_C$, entre 600°C et Ac1, Ac1 désignant la température de début de transformation austénitique au chauffage puis réchauffées jusqu'à une température Tm et maintenues à la température Tm pendant une durée Dm.

Selon un premier ensemble d'essais, les tôles ont été refroidies à une vitesse $V_R$ jusqu'à une température Te, puis maintenues à la température Te pendant une durée De.

Ces essais ont été réalisés selon cinq conditions de traitement différentes (a à e), indiquées dans le tableau 3.

Selon un sixième essai (f dans le tableau 3), les tôles ont été refroidies à partir de la température Tm jusqu'à la température ambiante, à une vitesse de refroidissement $V_R$, sans maintien à une température intermédiaire entre Tm et la température ambiante. Dans le tableau 3, NA signifie non applicable. En effet, selon le traitement f, aucun maintien à une température Te n'est effectué et le temps de maintien De n'est donc pas pertinent.

Les tôles fabriquées sont ainsi des tôles non revêtues.

Tableau 3

| Traitement | $V_C$ (°C/s) | Tm (°C) | Dm(s) | $V_R$ (°C/s) | Te (°C) | De (s) |
|---|---|---|---|---|---|---|
| a | 2 | 810 | 120 | 30 | 460 | 130 |
| b | 2 | 830 | 120 | 30 | 460 | 130 |
| c | 6 | 820 | 60 | 26 | 470 | 33 |
| d | 0,2 | 820 | 2 | 26 | 460 | 33 |
| e | 0,2 | 820 | 60 | 26 | 460 | 33 |
| f | 2 | 830 | 120 | >100°C/s | 20 | NA |

Les valeurs soulignées sont non-conformes à l'invention.

Au moyen d'essais de traction, on a déterminé la limite d'élasticité Ys, la résistance à la rupture TS et l'allongement total A des tôles obtenues par ces différents modes de fabrication. On a également déterminé l'aptitude au pliage de ces tôles en déterminant l'angle maximal avant rupture.

L'angle maximal avant rupture d'une tôle est déterminé en appliquant un poinçon sur les tôles de manière à plier cette tôle. La force à appliquer pour réaliser le pliage croît jusqu'à la rupture de la tôle. La mesure de la force appliquée lors du pliage permet ainsi de détecter l'amorçage de la rupture de la tôle, et de mesurer l'angle de pliage lorsque cette rupture intervient.

On a par ailleurs déterminé le rapport d'expansion de trou Ac% de chaque tôle en réalisant un trou par découpe dans la tôle au moyen d'un outil tronconique de façon à réaliser une expansion au niveau des bords de ce trou. Comme décrit dans la norme ISO 16630 :2009, on a mesuré le diamètre initial Di du trou avant emboutissage, puis le diamètre final Df du trou après emboutissage, au moment où l'on observe des fissures traversantes dans l'épaisseur de la tôle sur les bords du trou. On a déterminé l'aptitude à l'expansion de trou Ac% selon la formule suivante :

$$Ac\% = 100 * \frac{D_f - D_i}{D_i} .$$

On a également déterminé la microstructure des aciers. Les fractions surfaciques de martensite (incluant la martensite auto-revenue et la martensite fraîche) et de bainite inférieure (conjointement), de martensite auto-revenue et de bainite inférieure (conjointement), et de bainite à faible quantité de carbures ont été quantifiées après attaque au bisulfite de sodium. La fraction surfacique de martensite fraîche a été quantifiée après attaque par un réactif NAOH-NaNO3.

On a également déterminé la fraction surfacique de ferrite grâce à des observations en microscopie optique et électronique à balayage où l'on a identifié la phase ferritique.

Les microstructures des tôles ont été portées au tableau 4 ci-dessous.

Tableau 4

| | Ac3'-10 Ac3'+30 (°C) | Tm (°C) | Martensite +bainite inférieure (%) | Martensite auto-revenue + bainite inférieure (%) | Martensite fraîche (%) | Bainite à faible quantité de carbures (%) | Austénite (%) | Ferrite (%) |
|---|---|---|---|---|---|---|---|---|
| **I1-b** | 795-835 | 830 | 95 | 91 | 4 | 5 | 0 | 0 |
| **I2-b** | 800-840 | 830 | 90 | 75 | 15 | 10 | 0 | 0 |
| **I3-b** | 798-838 | 830 | 95 | 89 | 6 | 5 | 0 | 0 |
| **I4-b** | 800-840 | 830 | 80 | 75 | 5 | 20 | 0 | 0 |
| **I5-b** | 798-838 | 830 | 80 | 70 | 10 | 20 | 0 | 0 |
| **I1-d** | 990-1030 | **820** | **50** | 0 | 50 | 0 | 0 | **50** |
| **I1-e** | 805-845 | 820 | **50** | 0 | 50 | **0** | 0 | **50** |
| **I4-f** | 800-840 | 830 | **98** | 95 | 3 | **2** | 0 | 0 |
| **R1-b** | 803-843 | 830 | 95 | 81 | 14 | **3** | 0 | 2 |
| **R2-b** | 805-845 | 830 | 60 | 30 | 30 | **40** | 0 | 0 |
| **R3-b** | 805-845 | 830 | 75 | 45 | 30 | 25 | 0 | 0 |
| **R3-c** | 815-855 | 820 | 60 | 30 | 30 | **38** | 0 | 2 |
| **R4-b** | 785-825 | **830** | 85 | 60 | 25 | 13 | 2 | 0 |
| **R5-b** | 820-860 | 830 | **50** | 25 | 25 | **50** | 0 | 0 |

(suite)

| | Ac3'-10 Ac3'+30 (°C) | Tm (°C) | Martensite +bainite inférieure (%) | Martensite auto-revenue + bainite inférieure (%) | Martensite fraîche (%) | Bainite à faible quantité de carbures (%) | Austénite (%) | Ferrite (%) |
|---|---|---|---|---|---|---|---|---|
| R5-c | 830-870 | **820** | **45** | 23 | **22** | **45** | 0 | **10** |
| R6-c | 830-870 | **820** | **45** | 9 | **36** | **45** | 0 | **10** |
| R7-a | 802-842 | 810 | **40** | 35 | 5 | **60** | 0 | 0 |
| R8-a | 804-844 | 810 | 95 | 85 | 10 | 5 | 0 | 0 |
| R9-a | 810-850 | 810 | **50** | **10** | **40** | **47** | 0 | 3 |

Les valeurs soulignées sont non-conformes à l'invention.
Les propriétés mécaniques des tôles ont été portées au tableau 5 ci-dessous.

Tableau 5

| | TS (MPa) | Ys (MPa) | A% | Pliage | Ac% |
|---|---|---|---|---|---|
| **I1-b** | 1299 | 913 | 7,3 | 62 | 61,8 |
| **I2-b** | 1303 | 945 | 6,6 | 59 | n.d. |
| **I3-b** | 1299 | 947 | 6,1 | 56 | 55 |
| **I4-b** | 1250 | 827 | 8,7 | 58 | 43,6 |
| **I5-b** | 1194 | 855 | 7,5 | 63 | n.d. |
| **I1-d** | **1081** | **660** | 10 | n.d. | n.d. |
| **I1-e** | **1096** | **655** | 9.2 | n.d. | n.d. |
| **I4-f** | **1422** | **1123** | 5.9 | n.d. | n.d. |
| **R1-b** | **1353** | 930 | 7,3 | 56 | 43,9 |
| **R2-b** | **1116** | 800 | 8 | 71 | n.d. |
| **R3-b** | **1131** | 821 | 7,6 | 56 | n.d. |
| **R3-c** | **1165** | **798** | 8,6 | n.d. | **37** |
| **R4-b** | 1253 | **759** | 9 | **50** | n.d. |
| **R5-b** | **1151** | **790** | 6,7 | 63 | n.d. |
| **R5-c** | **1137** | **720** | 10,4 | n.d. | **30** |
| **R6-c** | 1208 | **777** | 10,7 | n.d. | **28** |
| **R7-a** | 1217 | **759** | 8,7 | 56 | n.d. |
| **R8-a** | 1262 | **792** | 8,4 | 59 | n.d. |
| **R9-a** | 1242 | **759** | 7,4 | 58 | n.d. |

Dans ce tableau, n.d. signifie que les valeurs des propriétés n'ont pas été déterminées.
L'analyse de ces résultats met en évidence les relations entre les compositions des aciers, leur microstructure et leurs propriétés mécaniques.

Les tôles d'acier I1-b, I2-b, I3-b, I4-b et I5-b présentent une composition et une microstructure conformes à l'invention. Par suite, ces tôles présentent une résistance mécanique, une limite d'élasticité, un allongement, un angle de pliage et un rapport d'expansion de trou qui satisfont aux valeurs visées.

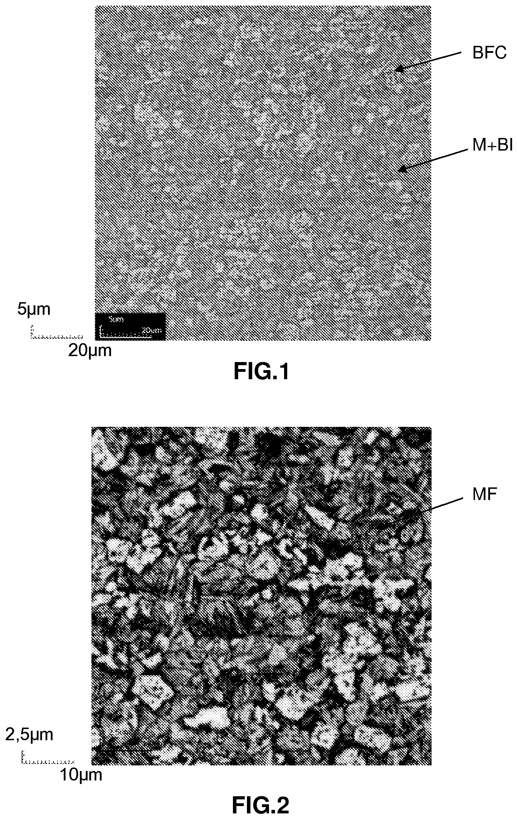

Les Figures 1 et 2 illustrent la microstructure de la tôle I4-b. La Figure 1 résulte d'une attaque de la tôle par bisulfite de sodium, tandis que la Figure 2 résulte de l'attaque de la tôle par le réactif NAOH-NaNO3. La Figure 1 fait apparaître la martensite auto-revenue et la bainite inférieure (M+BI), ainsi que la bainite à faible quantité de carbures (BFC). La Figure 2 fait apparaître, sous forme de zones plus sombres, la martensite fraîche (MF).

La tôle selon l'exemple R1-b présente une teneur en Cr trop élevée et une teneur en B trop élevée, de telle sorte que sa résistance mécanique TS est trop élevée. Ainsi, bien que l'on obtienne une limite d'élasticité Ys satisfaisante, cette limite d'élasticité est obtenue conjointement avec une résistance mécanique TS trop élevée.

Les tôles selon les exemples R2-b et R3-b présentent une teneur en C trop faible, et ne présentent ainsi pas une résistance mécanique satisfaisante.

En particulier, la tôle selon l'exemple R2-b comprend une fraction de bainite à faible quantité de carbures élevée, en raison de la faible teneur en C de l'acier formant la tôle, ce qui conduit à l'obtention d'une résistance mécanique peu élevée.

En outre, une teneur faible en C conduit à augmenter la température Ac3, et de fait la température Ac3'.

Pour l'exemple R3, selon la condition de fabrication c, il se forme donc un nombre trop important de petits grains d'austénite, ce qui conduit à la formation à l'issue du recuit d'une proportion surfacique de martensite auto-revenue et de bainite inférieure trop faible, d'une proportion de martensite fraîche trop élevée, et d'une proportion surfacique de bainite à faible quantité de carbures trop élevée.

Ceci conduit à l'obtention d'une résistance TS et d'une limite d'élasticité $Y_S$ insuffisantes, et à un rapport d'expansion de trou inférieur au rapport minimal recherché.

La tôle selon l'exemple R4-b présente des teneurs en C et Mn trop élevées, des teneurs en Cr et Si trop faible, une teneur en Nb trop élevée et une teneur en B trop faible, qui conduisent à l'obtention d'un angle de pliage trop faible.

En particulier, les teneurs en Mn et C élevées dans l'exemple R4-b conduisent à la formation trop importante de martensite fraîche sous forme de bandes, ce qui entraîne une dégradation de l'angle de pliage. En outre, en raison des fortes teneurs en carbone et en manganèse, la soudabilité de l'acier est dégradée. Notamment, le carbone équivalent Ceq déterminé à partir de la formule de Nishi précitée est égal à 0,34%, donc supérieur à la valeur maximale 0,30% souhaitée.

L'exemple R5 présente une teneur en Mn trop faible, ce qui, combiné à une teneur en Si importante (0,507%), conduit à une formation trop importante de bainite à faible quantité de carbures selon les traitements b et c.

Ainsi, les exemples R5-b et R5-c ont une résistance mécanique et une limite d'élasticité insuffisantes.

En outre, la teneur en Mn trop faible conduit à une température Ac3=820°C élevée. Selon la condition de fabrication c, Ac3'=840°C a donc une valeur élevée, de telle sorte que la température Tm=820°C est inférieure à Ac3'-10°C. De ce fait, l'austénitisation n'est pas complète, et il subsiste dans l'acier une proportion surfacique trop importante de ferrite, et trop peu de martensite auto-revenue et de bainite inférieure.

Par conséquent, la résistance mécanique TS et la limite d'élasticité $Y_S$ sont insuffisantes, de même que le rapport d'expansion de trou Ac%.

De même, l'exemple R6 présente une teneur en Mn trop faible, ce qui, combiné à une teneur en Si importante (0,511%), conduit à une formation trop importante de bainite à faible quantité de carbures.

En outre, la teneur en Mn trop faible qui conduit à une température Ac3=820°C élevée, de telle sorte que selon la route C, la température Tm=820°C est inférieure à Ac3'-10°C=830°C.

De ce fait, l'austénitisation n'est pas complète, et il subsiste dans l'acier une proportion surfacique trop importante de ferrite, et trop peu de martensite auto-revenue et de bainite inférieure. La limite d'élasticité et le rapport d'expansion de trou sont par conséquents dégradés. Néanmoins, la teneur importante en Mo permet de maintenir une résistance mécanique TS importante.

L'exemple R7 a une teneur en Mo trop élevée. En raison de la faible teneur en Nb de l'exemple R7, cette forte teneur en Mo a pour conséquence de diminuer la taille des anciens grains austénitiques, donc conduit, en raison de l'abaissement de la valeur de la température $M_S$, à une formation insuffisante de martensite et de bainite inférieure, notamment de martensite auto-revenue et de bainite inférieure à l'issue du recuit et à une formation trop importante de martensite fraîche.

Il en résulte pour l'exemple R7 a une limite d'élasticité insuffisante. Néanmoins, la teneur importante en Mo permet de maintenir une résistance mécanique TS élevée.

La composition de l'acier R8 présente également une teneur en Mo trop élevée.

L'exemple R9 présente une teneur en Si trop élevée, conduisant à une formation trop importante de bainite à faible quantité de carbures et à une formation insuffisante de martensite et de bainite inférieure, ce qui conduit à l'obtention d'une limite d'élasticité insuffisante. Pour l'exemple I1-d, la vitesse de chauffage Vc et la durée de maintien Dm sont trop faibles. Ainsi, la température Tm est inférieure à Ac3'-10. De ce fait, l'austénitisation n'est pas complète, et on observe une croissance trop importante des grains de ferrite. Il subsiste ainsi dans l'acier une proportion surfacique trop importante de ferrite, trop peu de martensite auto-revenue et de bainite inférieure, et trop peu de bainite à faible quantité de carbures. La résistance mécanique et la limite d'élasticité sont donc insuffisantes.

Pour l'exemple I1-e, la vitesse de chauffage Vc est trop faible. Ainsi, on observe une croissance trop importante des grains de ferrite. Il subsiste ainsi dans l'acier une proportion surfacique trop importante de ferrite, trop peu de martensite auto-revenue et de bainite inférieure, et trop peu de bainite à faible quantité de carbures. La résistance mécanique et la limite d'élasticité sont donc insuffisantes.

Pour l'exemple I4-f, la vitesse de refroidissement $V_R$ est trop élevée. Ainsi, il se forme trop de martensite et de bainite inférieure, et pas assez de bainite à faible quantité de carbures et de martensite fraîche.

La résistance mécanique et la limite d'élasticité sont donc bien au-delà de celles visées.

## Revendications

**1.** Tôle d'acier laminée à froid et recuite, dont la composition chimique comprend, les teneurs étant exprimées en poids :

$$0,10 \leq C \leq 0,13\%$$

$$2,4 \leq Mn \leq 2,8\%$$

$$0,30 \leq Si \leq 0,55\%$$

$$0,30 \leq Cr \leq 0,56\%$$

$$0,020 \leq Ti \leq 0,050\%$$

$$0,0020 \leq B \leq 0,0040\%$$

$$0,005 \leq Al \leq 0,050\%$$

$$Mo \leq 0,010\%$$

$$Nb \leq 0,040\%$$

$$0,002 \leq N \leq 0,008\%$$

$$S \leq 0,005\%$$

$$P \leq 0,020\%,$$

le reste étant constitué de fer et d'impuretés inévitables provenant de l'élaboration, la tôle ayant une microstructure constituée, en proportion surfacique, de martensite et/ou de bainite inférieure, ladite martensite comprenant de la martensite fraîche et/ou de la martensite auto-revenue, ladite microstructure comprenant en proportion surfacique de 40 à 95% de martensite auto-revenue et de bainite inférieure, la somme des proportions surfaciques de martensite et de bainite inférieure étant comprise entre 60 à 95%, de 4 à 35% de bainite à faible quantité de carbures, contenant moins de 100 carbures par unité de surface de 100 micromètres carrés, de 0 à 5% de ferrite, moins de 5% d'austénite résiduelle sous forme d'îlots et moins de 20% de martensite fraîche.

2. Tôle d'acier selon la revendication 1, **caractérisée en ce que** ladite microstructure comprend en proportion surfacique de 4% à 20% de martensite fraîche, préférentiellement de 4% à 15%.

3. Tôle d'acier selon la revendication 1, **caractérisée en ce que** ladite martensite auto-revenue et ladite bainite inférieure contiennent des carbures sous forme de bâtonnets orientés dans les directions <111> des lattes martensitiques et bainitiques.

4. Tôle d'acier selon l'une quelconque des revendications 1 à 3, **caractérisée en ce que** ladite microstructure comprend en proportion surfacique de 4 à 5% de ferrite.

5. Tôle d'acier selon l'une quelconque des revendications 1 à 4, **caractérisée en ce que** la plus petite dimension desdits îlots d'austénite résiduelle est inférieure à 50 nanomètres.

6. Tôle d'acier selon l'une quelconque des revendications 1 à 5, **caractérisée en ce que** la fraction des anciens grains austénitiques créés par le recuit dont la taille est inférieure à moins de un micromètre représente moins de 10% de la population totale desdits anciens grains austénitiques.

7. Tôle d'acier selon l'une quelconque des revendications 1 à 6, **caractérisée en ce que** ladite tôle a une résistance mécanique comprise entre 1180 MPa et 1320 MPa, et un rapport d'expansion de trou Ac% selon la norme ISO 16630 :2009 supérieur ou égal à 40%.

8. Tôle d'acier selon l'une quelconque des revendications 1 à 7, **caractérisée en ce que** ladite tôle a une épaisseur comprise entre 0,7 mm et 1,5 mm, et **en ce que** ladite tôle a un angle de pliage supérieur ou égal à 55°.

9. Tôle d'acier selon l'une quelconque des revendications 1 à 8, **caractérisée en ce que** la composition chimique comprend, la teneur étant exprimée en poids :

$$2,5 \leq Mn \leq 2,8\%.$$

10. Tôle d'acier selon l'une quelconque des revendications 1 à 9, **caractérisée en ce que** la composition chimique comprend, la teneur étant exprimée en poids :

$$0,30 \leq Si \leq 0,5\%.$$

11. Tôle d'acier selon l'une quelconque des revendications 1 à 10, **caractérisée en ce que** la composition chimique comprend, la teneur étant exprimée en poids :

$$0,005 \leq Al \leq 0,030\%.$$

12. Tôle d'acier selon l'une quelconque des revendications 1 à 11, **caractérisée en ce que** ladite tôle comporte un revêtement de zinc ou d'alliage de zinc, obtenu au trempé.

13. Tôle d'acier selon la revendication 12, **caractérisé en ce que** ledit revêtement de zinc ou d'alliage de zinc est un revêtement galvanisé-allié, ledit revêtement de zinc ou d'alliage de zinc comprenant de 7 à 12% en poids de fer.

14. Tôle d'acier selon l'une quelconque des revendications 1 à 11, **caractérisée en ce que** ladite tôle comporte un revêtement de zinc ou d'alliage de zinc, obtenu par dépôt sous vide.

15. Procédé de fabrication d'une tôle laminée à froid et recuite selon l'une quelconque des revendications 1 à 13, comprenant les étapes successives suivantes :

   - on approvisionne un demi-produit dont la composition chimique comprend, les teneurs étant exprimées en poids :

$$0,10 \leq C \leq 0,13\%$$

$$2,4 \leq Mn \leq 2,8\%$$

$$0,30 \leq Si \leq 0,55\%$$

$$0,30 \leq Cr \leq 0,56\%$$

$$0,020 \leq Ti \leq 0,050\%$$

$$0,0020 \leq B \leq 0,0040\%$$

$$0,005 \leq Al \leq 0,050\%.$$

$$Mo \leq 0,010\%$$

$$Nb \leq 0,040\%$$

$$0,002 \leq N \leq 0,008\%$$

$$S \leq 0,005\%$$

$$P \leq 0,020\%$$

le reste étant constitué de fer et d'impuretés inévitables provenant de l'élaboration, puis

- on chauffe ledit demi-produit à une température $T_{reheat}$ supérieure ou égale à 1250°C, puis
- on lamine à chaud ledit demi-produit, la température de fin de laminage étant supérieure à la température Ar3 de début de transformation de l'austénite au refroidissement, pour obtenir une tôle laminée à chaud, puis
- on refroidit ladite tôle laminée à chaud à une vitesse suffisante pour éviter la formation de ferrite et de perlite, puis
- on bobine ladite tôle laminée à chaud à une température inférieure à 580°C, puis
- on lamine à froid ladite tôle laminée à chaud pour obtenir une tôle laminée à froid, puis
- on réchauffe ladite tôle laminée à froid entre 600°C et Ac1, Ac1 désignant la température de début de transformation austénitique au chauffage, avec une vitesse de réchauffage $V_R$ comprise entre 1 et 20°C/s, puis
- on réchauffe ladite tôle laminée à froid jusqu'à une température Tm comprise entre Ac3'-10°C et Ac3'+30°C, et on maintient à la température Tm ladite tôle laminée à froid pendant une durée Dm comprise entre 50 et 150 secondes, avec Ac3'=Min{Ac3+1200/Dm ;1000°C}, où Ac3 et Ac3' sont exprimées en degrés Celsius et Dm en secondes, et où Ac3 désigne la température de fin de transformation austénitique au chauffage telle que déterminée indépendamment du temps de maintien à cette température Ac3, puis
- on refroidit la tôle à une vitesse comprise entre 10 et 150°C/s jusqu'à une température Te comprise entre 460°C et 490°C, puis
- on maintient ladite tôle à la température Te pendant une durée comprise entre 5 et 150 secondes, puis

- on revêt la tôle par passage en continu en immersion dans un bain de zinc ou en alliage de zinc à une température TZn comprise entre 450°C et 480°C, lesdites températures Te et TZn étant telles que $0 \leq$ (Te-TZn) $\leq 10$°C, puis
- on réchauffe optionnellement la tôle revêtue à une température comprise entre 490°C et 550°C pendant une durée $t_G$ comprise entre 10 s et 40 s.

16. Procédé de fabrication d'une tôle laminée à froid et recuite selon l'une quelconque des revendications 1 à 11 et 14, comprenant les étapes successives suivantes :

- on approvisionne un demi-produit dont la composition chimique comprend, les teneurs étant exprimées en poids :

$$0,10 \leq C \leq 0,13\%$$

$$2,4 \leq Mn \leq 2,8\%$$

$$0,30 \leq Si \leq 0,55\%$$

$$0,30 \leq Cr \leq 0,56\%$$

$$0,020 \leq Ti \leq 0,050\%$$

$$0.0020 \leq B \leq 0,0040\%$$

$$0,005 \leq Al \leq 0,050\%.$$

$$Mo \leq 0,010\%$$

$$Nb \leq 0,040\%$$

$$0,002 \leq N \leq 0,008\%$$

$$S \leq 0,005\%$$

$$P \leq 0,020\%$$

le reste étant constitué de fer et d'impuretés inévitables provenant de l'élaboration, puis

- on chauffe ledit demi-produit à une température $T_{reheat}$ supérieure ou égale à 1250°C, puis
- on lamine à chaud ledit demi-produit, la température de fin de laminage étant supérieure à Ar3, pour obtenir une tôle laminée à chaud, puis
- on refroidit ladite tôle laminée à chaud à une vitesse suffisante pour éviter la formation de ferrite et de perlite, puis
- on bobine ladite tôle laminée à chaud à une température inférieure à 580°C, puis
- on lamine à froid ladite tôle laminée à chaud pour obtenir une tôle laminée à froid, puis
- on réchauffe ladite tôle laminée à froid avec une vitesse de réchauffage VR, entre 600°C et Ac1, Ac1 désignant la température de début de transformation austénitique au chauffage, comprise entre 1 et 20°C/s, puis

- on réchauffe ladite tôle laminée à froid jusqu'à une température Tm comprise entre Ac3-10°C et Ac3+30°C, et on maintient à la température Tm ladite tôle laminée à froid pendant une durée Dm comprise entre 50 et 150 secondes, avec Ac3'=Min{Ac3+1200/Dm ;1000°C}, où Ac3 et Ac3' sont exprimées en degrés Celsius et Dm en secondes, et où Ac3 désigne la température de fin de transformation austénitique au chauffage telle que déterminée indépendamment du temps de maintien à cette température Ac3, puis
- on refroidit la tôle à une vitesse comprise entre 10 et 100°C/s jusqu'à une température Te comprise entre 460°C et 490°C, puis
- on maintient ladite tôle à la température Te pendant une durée comprise entre 5 et 150 secondes, puis
- on refroidit ladite tôle jusqu'à la température ambiante.

**17.** Procédé de fabrication d'une tôle laminée à froid, recuite et revêtue, selon la revendication 16, dans lequel on effectue en outre un revêtement de zinc ou d'alliage de zinc par dépôt sous vide après ladite étape de refroidissement jusqu'à la température ambiante.

**18.** Procédé de fabrication d'une tôle selon la revendication 17, **caractérisé en ce que** ledit dépôt sous vide est effectué par dépôt physique en phase vapeur (PVD).

**19.** Procédé de fabrication d'une tôle selon la revendication 17, **caractérisé en ce que** ledit dépôt sous vide est effectué par Jet Vapour Deposition (JVD).

**Patentansprüche**

**1.** Kaltgewalztes und geglühtes Stahlblech, dessen chemische Zusammensetzung aufweist, wobei die Gehalte in Gewicht ausgedrückt sind:

$$0,10 \leq C \leq 0,13\%$$

$$2,4 \leq Mn \leq 2,8\%$$

$$0,30 \leq Si \leq 0,55\%$$

$$0,30 \leq Cr \leq 0,56\%$$

$$0,020 \leq Ti \leq 0,050\%$$

$$0,0020 \leq B \leq 0,0040\%$$

$$0,005 \leq Al \leq 0,050\%$$

$$Mo \leq 0,010\%$$

$$Nb \leq 0,040\%$$

$$0,002 \leq N \leq 0,008\%$$

$$S \leq 0,005\%$$

$$P \leq 0,020\%,$$

wobei der Rest gebildet ist von Eisen und unvermeidbaren, aus der Bearbeitung stammenden Verunreinigungen, wobei das Blech eine Mikrostruktur hat, die gebildet ist, in Flächenverhältnis, aus Martensit und/oder niederem Bainit, wobei der Martensit aufweist Frisch-Martensit und/oder eigenentspannten Martensit, wobei die Mikrostruktur in Flächenverhältnis aufweist 40-95% eigenentspannten Martensit und niederen Bainit, wobei die Summe der Flächenverhältnisse von Martensit und von niederem Bainit zwischen 60 bis 95% liegen, bei 4 bis 35% Bainit mit geringer Quantität an Karbiden, enthaltend wenigstens 100 Karbide pro Flächeneinheit von 100 Quadratmikrometern, 0 bis 5% Ferrit, wenigstens 5% Rest-Austenit in der Form von Inseln und wenigstens 20% Frisch-Martensit.

2. Stahlblech gemäß Anspruch 1, **dadurch gekennzeichnet, dass** die Mikrostruktur in Flächenverhältnis aufweist 4% bis 20%, bevorzugt 4% bis 15%, Frisch-Martensit.

3. Stahlblech gemäß Anspruch 1, **dadurch gekennzeichnet, dass** der eigenentspannte Martensit und der niedere Bainit Karbide in Form von Stäbchen aufweist, die in die Richtungen <111> von Martensit- und Bainit-Leisten orientiert sind.

4. Stahlblech gemäß irgendeinem der Ansprüche 1 bis 3, **dadurch gekennzeichnet, dass** die Mikrostruktur in Flächenverhältnis 4 bis 5% Ferrit aufweist.

5. Stahlblech gemäß irgendeinem der Ansprüche 1 bis 4, **dadurch gekennzeichnet, dass** die kleinste Abmessung der Inseln von Rest-Austenit kleiner als 50 Nanometer ist.

6. Stahlblech gemäß irgendeinem der Ansprüche 1 bis 5, **dadurch gekennzeichnet, dass** die Fraktion von alten Austenit-Körnern, die erzeugt wurden durch das Glühen, deren Größe kleiner als wenigstens ein Mikrometer ist, wenigstens 10% des Gesamtbestands der besagten alten Austenit-Körner ist.

7. Stahlblech gemäß irgendeinem der Ansprüche 1 bis 6, **dadurch gekennzeichnet, dass** das besagte Blech eine mechanische Festigkeit, die zwischen 1180 MPa und 1320 MPa liegt, und ein Lochaufweitungsverhältnis Ac% gemäß der Norm ISO 16630:2009 hat, das größer oder gleich 40% ist.

8. Stahlblech gemäß irgendeinem der Ansprüche 1 bis 7, **dadurch gekennzeichnet, dass** das besagte Blech eine Dicke hat, die zwischen 0,7 mm und 1,5 mm liegt, und dass das besagte Blech einen Biegewinkel größer oder gleich 55° Grad hat.

9. Stahlblech gemäß irgendeinem der Ansprüche 1 bis 8, **dadurch gekennzeichnet, dass** die chemische Zusammensetzung aufweist, wobei der Gehalt in Gewicht ausgedrückt ist:

$$2,5 \leq Mn \leq 2,8\%.$$

10. Stahlblech gemäß irgendeinem der Ansprüche 1 bis 9, **dadurch gekennzeichnet, dass** die chemische Zusammensetzung aufweist, wobei der Gehalt in Gewicht ausgedrückt ist:

$$0,30 \leq Si \leq 0,5\%.$$

11. Stahlblech gemäß irgendeinem der Ansprüche 1 bis 10, **dadurch gekennzeichnet, dass** die chemische Zusammensetzung aufweist, wobei der Gehalt in Gewicht ausgedrückt ist:

$$0,005 \leq Al \leq 0,030\%.$$

**12.** Stahlblech gemäß irgendeinem der Ansprüche 1 bis 11, **dadurch gekennzeichnet, dass** das besagte Blech aufweist eine Beschichtung aus Zink oder einer Zinklegierung, erhalten durch Tauchen.

**13.** Stahlblech gemäß Anspruch 12, **dadurch gekennzeichnet, dass** die besagte Beschichtung aus Zink oder Zinklegierung eine galvanisierte-legierte Beschichtung ist, wobei die besagte Beschichtung aus Zink oder Zinklegierung 7 bis 12 Gewichts-% Eisen aufweist.

**14.** Stahlblech gemäß irgendeinem der Ansprüche 1 bis 11, **dadurch gekennzeichnet, dass** das besagte Blech aufweist eine Beschichtung aus Zink oder Zinklegierung, erhalten durch Vakuumabscheidung.

**15.** Verfahren zur Herstellung eines kaltgewalzten und geglühten Stahlblechs gemäß irgendeinem der Ansprüche 1 bis 13, aufweisend die folgenden Schritte:

- Bereitstellen eines Halbzeugs, dessen chemische Zusammensetzung aufweist, wobei die Gehalte in Gewicht ausgedrückt sind:

$$0,10 \leq C \leq 0,13\%$$

$$2,4 \leq Mn \leq 2,8\%$$

$$0,30 \leq Si \leq 0,55\%$$

$$0,30 \leq Cr \leq 0,56\%$$

$$0,020 \leq Ti \leq 0,050\%$$

$$0,0020 \leq B \leq 0,0040\%$$

$$0,005 \leq Al \leq 0,050\%$$

$$Mo \leq 0,010\%$$

$$Nb \leq 0,040\%$$

$$0,002 \leq N \leq 0,008\%$$

$$S \leq 0,005\%$$

$$P \leq 0,020\%,$$

wobei der Rest gebildet von Eisen und unvermeidbaren, von der Bearbeitung stammenden Verunreinigungen, dann
- Erwärmen des Halbzeugs auf eine Temperatur $T_{reheat}$, die größer oder gleich 1250°C ist, dann
- Warmwalzen des Halbzeugs, wobei die End-Walztemperatur größer ist als die Temperatur Ar3 des Beginns der Austenit-Umwandlung bei Abkühlung, zum Erlangen eines warmgewalzten Blechs, dann
- Abkühlen des besagten warmgewalzten Blechs "mit einer Geschwindigkeit, die ausreicht zum Vermeiden der Bildung von Ferrit und Perlit, dann

- Aufwickeln des warmgewalzten Stahlblechs bei einer Temperatur kleiner als 580°C, dann

- Kaltwalzen des besagten warmgewalzten Blechs zum Erlangen eines kaltgewalzten Blechs,

- Erwärmen des kaltgewalzten Blechs zwischen 600°C und Ac1, wobei Ac1 die Temperatur des Beginns der Austenit-Umwandlung bei Erwärmung bezeichnet, mit einer AufwärmGeschwindigkeit von $V_R$, die zwischen 1 und 20°C/s liegt, dann

- Erwärmen des besagten kaltgewalzten Blechs auf eine Temperatur Tm, die zwischen Ac3'-10°C und Ac3'+30°C liegt, und Aufrechterhalten des besagten kaltgewalzten Blechs bei der Temperatur Tm während einer Dauer Dm, die zwischen 50 und 150 Sekunden liegt, mit Ac3'=Min{Ac3+1200/Dm; 1000°C}, wobei Ac3 und Ac3' ausgedrückt sind in Grad Celsius und Dm in Sekunden, und wobei Ac3 die Austenit-Umwandlungsendtemperatur bei Erwärmen bezeichnet, wie unabhängig bestimmt von der Zeit des Haltens dieser Temperatur Ac3, dann

- Abkühlen des Blechs mit einer Geschwindigkeit, die zwischen 10 und 150°C/s liegt, bis auf eine Temperatur Te, die zwischen 460°C und 490°C liegt, dann

- Aufrechterhalten des besagten Blechs bei der Temperatur Te während einer Dauer, die zwischen 5 und 150 Sekunden liegt, dann

- Beschichten des Blechs durch kontinuierliches Tauch-Passieren eines Zink- oder Zinklegierungsbads mit einer Temperatur TZn, die zwischen 450°C und 480°C liegt, wobei die besagten Temperaturen Te und TZn so sind, dass $0 \leq (Te-TZn) \leq 10°C$, dann

- optionales Erwärmen des beschichteten Blechs auf eine Temperatur, die zwischen 490°C und 550°C liegt, während einer Zeit $t_G$, die zwischen 10s und 40s liegt.

16. Verfahren zur Herstellung eines kaltgewalzten und geglühten Blechs gemäß irgendeinem der Ansprüche 1 bis 11 und 14, aufweisend die nachfolgenden sukzessiven Schritte,

- Bereitgestellen eines Halbzeugs, dessen chemische Zusammensetzung aufweist, wobei die Gehalte in Gewicht ausgedrückt sind:

$$0,10 \leq C \leq 0,13\%$$

$$2,4 \leq Mn \leq 2,8\%$$

$$0,30 \leq Si \leq 0,55\%$$

$$0,30 \leq Cr \leq 0,56\%$$

$$0,020 \leq Ti \leq 0,050\%$$

$$0,0020 \leq B \leq 0,0040\%$$

$$0,005 \leq Al \leq 0,050\%$$

$$Mo \leq 0,010\%$$

$$Nb \leq 0,040\%$$

$$0,002 \leq N \leq 0,008\%$$

$$S \leq 0{,}005\%$$

$$P \leq 0{,}020\%,$$

wobei der Rest gebildet ist von Eisen und unvermeidbaren, von der Bearbeitung stammenden Verunreinigungen, dann

- Erwärmen des Halbzeugs auf eine Temperatur $T_{reheat}$, die größer oder gleich 1250°C ist, dann
- Warmwalzen des Halbzeugs, wobei die End-Walztemperatur größer ist als Ar3, zum Erlangen eines warmgewalzten Blechs, dann
- Abkühlen des besagten warmgewalzten Blechs mit einer Geschwindigkeit, die ausreicht zum Vermeiden der Bildung von Ferrit und Perlit, dann
- Aufwickeln des warmgewalzten Stahlblechs bei einer Temperatur kleiner als 580°C, dann
- Kaltwalzen des besagten warmgewalzten Blechs zum Erlangen eines kaltgewalzten Blechs,
- Erwärmen des kaltgewalzten Blechs zwischen 600°C und Ac1, wobei Ac1 die Temperatur des Beginns der Austenit-Umwandlung bei Erwärmung bezeichnet, mit einer AufwärmGeschwindigkeit von VR, die zwischen 1 und 20°C/s liegt, dann
- Erwärmen des besagten kaltgewalzten Blechs bis auf eine Temperatur Tm, die zwischen Ac3-10°C und Ac3+30°C liegt, und Aufrechterhalten der Temperatur Tm des besagten kaltgewalzten Blechs während einer Dauer Dm, die zwischen 50 und 150 Sekunden liegt, mit Ac3'=Min{Ac3+1200/Dm; 1000°C}, wobei Ac3 und Ac3' ausgedrückt sind in Grad Celsius und Dm in Sekunden, und wobei Ac3 die Austenit-Umwandlungsendtemperatur bei Erwärmen bezeichnet, wie unabhängig bestimmt von der Zeit des Haltens dieser Temperatur Ac3, dann
- Abkühlen des Blechs mit einer Geschwindigkeit, die zwischen 10 und 100°C/s liegt, bis auf eine Temperatur Te, die zwischen 460°C und 490°C liegt, dann
- Aufrechterhalten des besagten Blechs bei der Temperatur Te während einer Dauer, die zwischen 5 und 150 Sekunden liegt, dann
- Abkühlen des besagten Blechs bis auf Umgebungstemperatur.

**17.** Verfahren zur Herstellung eines kaltgewalzten, geglühten und beschichteten Blechs gemäß Anspruch 16, wobei man ferner durchführt ein Zink- oder Zinklegierungs-Beschichten durch Vakuumabscheidung nach dem besagten Schritt des Abkühlens auf Umgebungstemperatur.

**18.** Verfahren zur Herstellung eines Blechs gemäß Anspruch 17, **dadurch gekennzeichnet, dass** das besagte Vakuumabscheiden durchgeführt wird durch physikalisches Abscheiden in Dampfphase (PVD).

**19.** Verfahren zur Herstellung eines Blechs gemäß Anspruch 17, **dadurch gekennzeichnet, dass** das besagte Abscheiden unter Vakuum durchgeführt wird durch Strahl-Dampfabscheiden (JVD).

**Claims**

**1.** A cold-rolled and annealed steel sheet, the chemical composition of which comprises, the contents being expressed by weight percent:

$$0.10 \leq C \leq 0.13\%$$

$$2.4 \leq Mn \leq 2.8\%$$

$$0.30 \leq Si \leq 0.55\%$$

$$0.30 \leq Cr \leq 0.56\%$$

$$0.020 \leq Ti \leq 0.050\%$$

$$0.0020 \leq B \leq 0.0040\%$$

$$0.005 \leq Al \leq 0.050\%$$

$$Mo \leq 0.010\%$$

$$Nb \leq 0.040\%$$

$$0.002 \leq N \leq 0.008\%$$

$$S \leq 0.005\%$$

$$P \leq 0.020\%,$$

the remainder consisting of iron and unavoidable impurities from the smelting, the steel sheet having a microstructure consisting of, in surface proportion, martensite and/or lower bainite, said martensite comprising fresh martensite and/or self-tempered martensite, said microstructure comprising, in surface proportion, 40 to 95% of self-tempered martensite and lower bainite, the sum of the surface percentages of martensite and lower bainite being comprised between 60 to 95%, 4 to 35% of low carbide containing bainite, containing less than 100 carbides per surface unit of 100 square micrometers, 0 to 5% of ferrite, less than 5% of retained austenite in island form and less than 20% of fresh martensite.

2. The steel sheet according to claim 1, **characterized in that** said microstructure comprises, in surface proportion, 4% to 20% of fresh martensite, preferably 4% to 15%.

3. The steel sheet according to claim 1, **characterized in that** said self-tempered martensite and said lower bainite contain rod-shaped carbides oriented in the directions <111> of the martensitic and bainite laths.

4. The steel sheet according to any one of claims 1 to 3, **characterized in that** said microstructure comprises, in surface proportion, 4 to 5% of ferrite.

5. The steel sheet according to any one of claims 1 to 4, **characterized in that** the smallest dimension of the retained austenite islands is smaller than 50 nanometers.

6. The steel sheet according to any one of claims 1 to 5, **characterized in that** the fraction of former austenite grains created by the annealing whose size is less than one micrometer represents less than 10% of the total population of said former austenite grains.

7. The steel sheet according to any one of claims 1 to 6, **characterized in that** said steel sheet has a tensile strength comprised between 1180 MPa and 1320 MPa, and a hole expansion ratio Ac% according to the standard ISO 16630 :2009 greater than or equal to 40%.

8. The steel sheet according to any one of claims 1 to 7, **characterized in that** said steel sheet has a thickness comprised between 0.7 mm and 1.5 mm, and **in that** said steel sheet has a bending angle greater than or equal to 55°.

9. The steel sheet according to any one of claims 1 to 8, **characterized in that** the chemical composition comprises, the content being expressed by weight percent:

$$2.5 \leq Mn \leq 2.8\%.$$

**10.** The steel sheet according to any one of claims 1 to 9, **characterized in that** the chemical composition comprises, the content being expressed by weight percent:

$$0.30 \leq Si \leq 0.5\%.$$

**11.** The steel sheet according to any one of claims 1 to 10, **characterized in that** the chemical composition comprises, the content being expressed by weight percent:

$$0.005 \leq Al \leq 0.030\%.$$

**12.** The steel sheet according to any one of claims 1 to 11, **characterized in that** said steel sheet comprises a zinc or zinc alloy coating, obtained through continuous dip coating.

**13.** The steel sheet according to claim 12, **characterized in that** said zinc or zinc alloy coating is a galvannealed coating, said zinc or zinc alloy coating comprising from 7 to 12% of iron.

**14.** The steel sheet according to any one of claims 1 to 11, **characterized in that** said steel sheet comprises a zinc or zinc alloy coating, obtained through vacuum deposition.

**15.** A method for manufacturing a cold-rolled and annealed steel sheet according to any one of claims 1 to 13, comprising the following successive steps:

- providing a semi-finished steel having a chemical composition comprising, the contents being expressed by weight percent:

$$0.10 \leq C \leq 0.13\%$$

$$2.4 \leq Mn \leq 2.8\%$$

$$0.30 \leq Si \leq 0.55\%$$

$$0.30 \leq Cr \leq 0.56\%$$

$$0.020 \leq Ti \leq 0.050\%$$

$$0.0020 \leq B \leq 0.0040\%$$

$$0.005 \leq Al \leq 0.050\%.$$

$$Mo \leq 0.010\%$$

$$Nb \leq 0.040\%$$

$$0.002 \leq N \leq 0.008\%$$

$$S \leq 0.005\%$$

$$P \leq 0.020\%$$

the remainder consisting of iron and unavoidable impurities resulting from the smelting, then

- heating said semi-finished steel to a temperature $T_{reheat}$ greater than or equal to 1250°C, then
- hot-rolling said semi-finished steel, the end-of-rolling temperature being greater than the temperature Ar3 of the beginning of transformation of the austenite upon cooling, to obtain a hot-rolled steel sheet, then
- cooling said hot-rolled steel sheet at a rate sufficient to avoid the formation of ferrite and perlite, then
- coiling said hot-rolled steel sheet at a temperature below 580°C, then
- cold-rolling said hot-rolled steel sheet to obtain a cold-rolled steel sheet, then
- reheating said cold-rolled steel sheet between 600°C and Ac1, Ac1 designating the beginning of austenitic transformation temperature upon heating, at a heating rate $V_R$ comprised between 1 and 20°C/s, then
- reheating said cold-rolled steel sheet to a temperature Tm comprised between Ac3'-10°C and Ac3'+30°C, and holding said cold-rolled steel sheet at said temperature Tm for a time Dm comprised between 50 and 150 seconds, with Ac3'=Min {Ac3+1200/Dm; 1000°C}, where Ac3 and Ac3' are expressed in degrees Celsius and Dm in seconds, and where Ac3 designates the end of austenitic transformation temperature upon heating as determined independently from the holding time at that temperature Ac3, then
- cooling the steel sheet at a rate comprised between 10 and 150°C/s to a temperature Te comprised between 460°C and 490°C, then
- holding said steel sheet at the temperature Te for a time comprised between 5 and 150 seconds, then
- coating the steel sheet by continuous dipping in a zinc or zinc alloy bath at a temperature TZn comprised between 450°C and 480°C, said temperatures Te and TZn being such that $0 \leq$ (Te-TZn) $\leq$10°C, then
- optionally heating the coated steel sheet to a temperature comprised between 490°C and 550°C for a time $t_G$ comprised between 10 s and 40 s.

**16.** A method for manufacturing a cold-rolled and annealed steel sheet according to any one of claims 1 to 11 and 14, comprising the following successive steps:

- providing a semi-finished steel having a chemical composition comprising, the contents being expressed by weight percent:

$$0.10 \leq C \leq 0.13\%$$

$$2.4 \leq Mn \leq 2.8\%$$

$$0.30 \leq Si \leq 0.55\%$$

$$0.30 \leq Cr \leq 0.56\%$$

$$0.020 \leq Ti \leq 0.050\%$$

$$0.0020 \leq B \leq 0.0040\%$$

$$0.005 \leq Al \leq 0.050\%$$

$$Mo \leq 0.010\%$$

$$Nb \leq 0.040\%$$

$$0.002 \leq N \leq 0.008\%$$

$$S \leq 0.005\%$$

$$P \leq 0.020\%$$

the remainder consisting of iron and unavoidable impurities from the smelting, then

- heating said semi-finished steel to a temperature $T_{reheat}$ greater than or equal to 1250°C, then
- hot-rolling said semi-finished steel, the end of rolling temperature being greater than Ar3, to obtain a hot-rolled steel sheet, then
- cooling said hot-rolled steel sheet at a rate sufficient to avoid the formation of ferrite and perlite, then
- coiling said hot-rolled steel sheet at a temperature below 580°C, then
- cold-rolling said hot-rolled steel sheet to obtain a cold-rolled steel sheet, then
- reheating said cold-rolled steel sheet between 600°C and Ac1, Ac1 designating the beginning of austenitic transformation temperature upon heating at a heating rate $V_R$, comprised between 1 and 20°C/s, then
- reheating said cold-rolled steel sheet to a temperature Tm comprised between Ac3-10°C and Ac3+30°C, and holding said cold-rolled steel sheet at said temperature Tm for a time Dm comprised between 50 and 150 seconds, with Ac3'=Min{Ac3+1200/Dm ;1000°C}, where Ac3 and Ac3' are expressed in degrees Celsius and Dm in seconds, and where Ac3 designates the end of austenitic transformation temperature upon heating as determined independently from the holding time at that temperature Ac3, then
- cooling the steel sheet at a rate comprised between 10 and 100°C/s to a temperature Te comprised between 460°C and 490°C, then
- holding said steel sheet at the temperature Te for a time comprised between 5 and 150 seconds, then
- cooling said steel sheet to ambient temperature.

**17.** The method for manufacturing a cold-rolled, annealed and coated steel sheet according to claim 16, wherein a zinc or zinc alloy coating is performed by vacuum deposition after said cooling step to ambient temperature.

**18.** The steel sheet manufacturing method according to claim 17, **characterized in that** said vacuum deposition is performed by physical vapor deposition (PVD).

**19.** The steel sheet manufacturing method according to claim 17, **characterized in that** said vacuum deposition is performed by jet vapor deposition (JVD).

5μm

20μm

**FIG.1**

2,5μm

10μm

**FIG.2**

# EP 3 084 014 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120312433 A1
- US 2012132327 A1
- US 20130209833 A1
- US 20110048589 A1
- EP 2258887 A1
- US 201101683000 A1
- WO 2013144376 A1

**Littérature non-brevet citée dans la description**

- **NISHI, T et al.** Evaluation of high-strength steels for automobile use. *Nippon Steel technical report,* 1982, vol. 20, 37-44
- Darstellung der Umwandlungen für technische Anwendungen und Möglichkeiten ihrer Beeinflussung. **H.P. HOUGARDY.** Werkstoffkunde Stahl. Verlag Stahleisen, 1984, vol. 1, 198-231
- **K.W. ANDREWS.** Empirical Formulae for the Calculation of Some Transformation Temperatures. *Journal of the Iron and Steel Institute,* 1965, vol. 203